**Europäisches Patentamt**

**European Patent Office**

**Office européen des brevets**

(19)

(11) Numéro de publication: **0 195 713**
**A1**

(12) # DEMANDE DE BREVET EUROPEEN

(21) Numéro de dépôt: **86400525.1**

(22) Date de dépôt: **12.03.86**

(51) Int. Cl.⁴: **H02M 3/155** , H03K 17/08

(30) Priorité: **15.03.85 FR 8503904**

(43) Date de publication de la demande:
**24.09.86 Bulletin 86/39**

(84) Etats contractants désignés:
**DE GB IT NL**

(71) Demandeur: **THOMSON-CSF**
**173, Boulevard Haussmann**
**F-75379 Paris Cedex 08(FR)**

(72) Inventeur: **Rambert, Bernard**
**THOMSON-CSF SCPI 19, avenue de Messine**
**F-75008 Paris(FR)**

(74) Mandataire: **El Manouni, Josiane**
**THOMSON-CSF SCPI 19, avenue de Messine**
**F-75008 Paris(FR)**

(54) **Dispositif d'aide à la commutation d'interrupteur et de diode de roue libre.**

(57) Ce dispositif d'aide à la commutation pour diode de roue libre (D) et pour interrupteur (T) utilisés dans un réseau électrique comportant par ailleurs une inductance (L), et composé d'un circuit d'aide à la mise en conduction et d'un circuit d'aide au blocage, comportant eux-mêmes respectivement un circuit (R-L$_i$) placé en série avec l'interrupteur, et un circuit (R-C) placé en parallèle avec l'interrupteur est tel qu'il puisse à la fois être utilisé comme réseau d'aide au reblocage tant pour la diode de roue libre (D) que pour l'interrupteur (T), la résistance (R) étant choisie non inductive et de valeur suffisamment faible pour que le produit $RI_{RM}$ (où $I_{RM}$désigne le courant inverse maximum de la roue libre (D) soit inférieur à la tension d'alimentation (E).

Application notamment aux alimentations à découpage et à la commande de moteurs électriques.

# FIG_2

EP 0 195 713 A1

## DISPOSITIF D'AIDE A LA COMMUTATION D'INTERRUPTEUR ET DE DIODE DE ROUE LIBRE

La présente invention concerne un dispositif d'aide à la commutation d'interrupteur et de diode de roue libre.

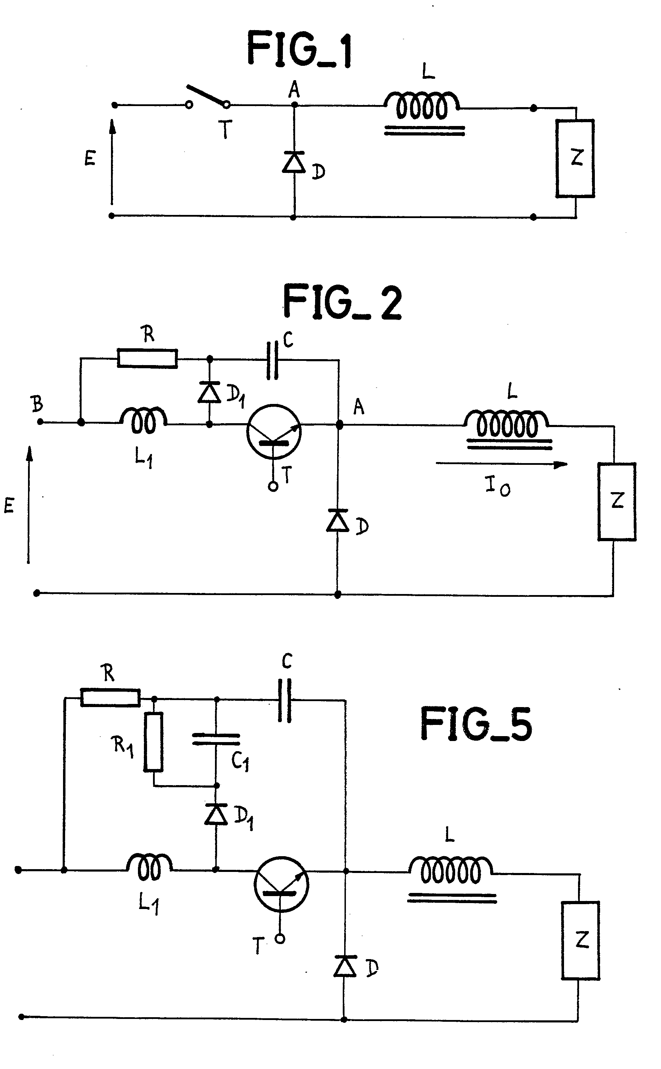

Elle concerne plus particulièrement un dispositif d'aide à la commutation d'un interrupteur et d'une diode de roue libre utilisés dans un réseau électrique tel que celui représenté sur la figure 1 comportant, outre cet interrupteur T et cette diode de roue libre D, une inductance L, ces trois composants étant répartis sur trois branches différentes aboutissant à un même noeud A, formant ainsi un tripôle connecté par ailleurs à une source de tension E et à une charge Z, de sorte que la charge Z est alimentée, soit via la source de tension E, l'interrupteur T et l'inductance L, soit via l'inductance L et la diode de roue libre D, suivant que l'interrupteur T est conducteur ou bloqué, et, corrélativement suivant que la diode de roue libre D est bloquée ou conductrice.

De tels réseaux électriques s'appliquent notamment dans les alimentations à découpage (telles que les montages "fly-back", "boost" . . .) ainsi que dans la commande de moteurs électriques. Le plus souvent, l'interrupteur est constitué par un transistor T.

Dans un tel réseau électrique, la présence de l'inductance L, qui impose le fait que le courant qui la parcourt ne peut pas varier brutalement à la mise en conduction ou au blocage du transistor T, serait une cause de dissipation de puissance très importante dans le transistor si aucun dispositif d'aide à la commutation du transistor n'était prévu.

En effet, en l'absence de dispositif d'aide à la mise en conduction du transistor, la tension aux bornes du transistor ne pourrait pas s'annuler tant que le courant dans le transistor n'aurait pas, au cours de sa croissance, atteint une certaine valeur, correspondant à la valeur $I_0$ du courant parcourant précédemment l'inductance ($I_{transistor}$ + $I_{diode}$ = $I_0$). Ce n'est qu'à partir de ce moment là que le courant dans la diode de roue libre pourrait s'annuler, donc que la tension aux bornes de cette diode pourrait devenir égale à la tension d'alimentation E, et partant que la tension aux bornes du transistor pourrait s'annuler. Mais auparavant, la puissance dissipée dans le transistor aurait pu atteindre des valeurs très importantes, pouvant aller jusqu'à la destruction de celui-ci.

De même, en l'absence de dispositif d'aide au blocage du transistor, la tension aux bornes du transistor deviendrait instantanément égale à la tension d'alimentation E, alors même que le courant dans celui-ci ne serait pas encore nul, car la seule décroissance du courant parcourant le transistor suffirait à déclencher le passage d'un courant dans la diode, donc à avoir une tension nulle aux bornes de la diode, et partant une tension égale à la tension d'alimentation E aux bornes du transistor. Mais, en attendant que le courant dans le transistor ne s'annule complètement, la puissance dissipée dans celui-ci aurait pu atteindre des valeurs très importantes, préjudiciables à son bon fonctionnement.

Un dispositif d'aide à la commutation du transistor comporte de manière connue, comme représenté sur la figure 2, un circuit d'aide à la mise en conduction du transistor, comportant lui-même un circuit "R-$L_1$" placé en série avec le transistor T. Ce circuit d'aide à la mise en conduction permet de faire coïncider le début de la croissance du courant dans le transistor avec l'annulation de la tension aux bornes de celui-ci.

Un dispositif d'aide à la commutation du transistor comporte également de manière connue un circuit d'aide au blocage, comportant lui-même un circuit "R-C" placé en parallèle sur le transistor. Ce circuit d'aide au blocage permet de faire croître progressivement la tension aux bornes du transistor au cours de la décroissance du courant dans celui-ci.

La résistance R est commune aux circuits "R-$L_1$" et "R-C". Une diode $D_1$ permet par ailleurs d'éviter un surcourant dans le transistor, en établissant, au moment du blocage du transistor, une dérivation de ce courant par la diode $D_1$ et le condensateur C, permettant par là même à ce condensateur de se charger, et en empêchant, au moment de la mise en conduction du transistor, le condensateur C de se décharger dans le transistor.

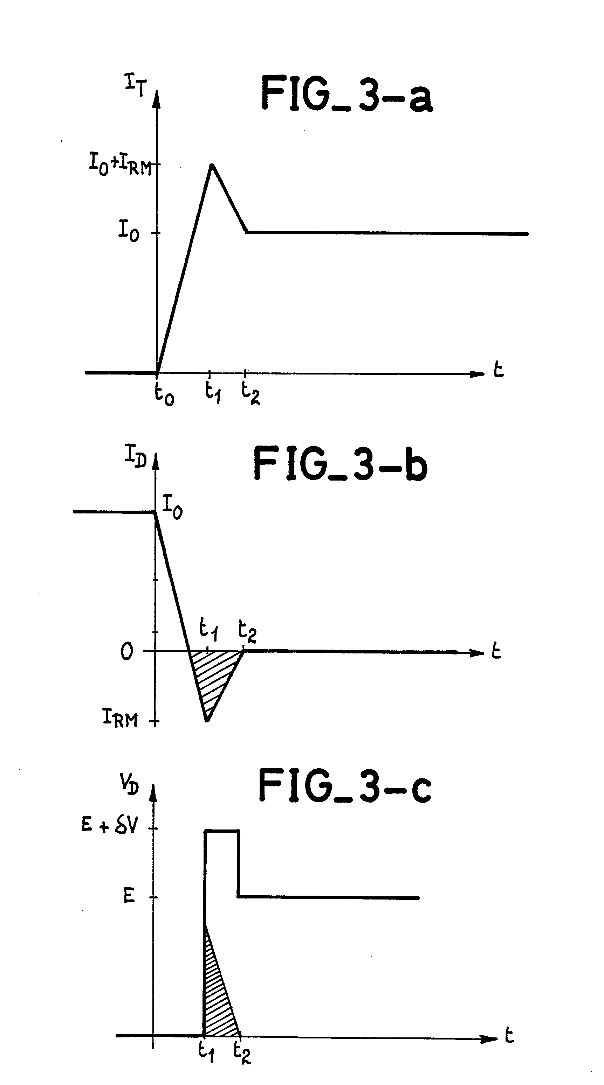

Un problème se pose toutefois, même en présence d'un réseau d'aide à la commutation du transistor. Ce problème est dû au fait que les diodes utilisées en pratique ne sont pas parfaites mais présentent au contraire un certain courant inverse lors de leur reblocage. Ce problème est mis en lumière sur les diagrammes des figures 3a, 3b et 3c représentant respectivement le courant $I_T$ dans le transistor T, le courant $I_D$ dans la diode D et la tension $V_D$ aux bornes de la diode D.

Le courant inverse décroît jusqu'à une valeur $I_{RM}$, appelée courant inverse maximum, à partir de laquelle la diode se rebloque, c'est-à-dire la tension aux bornes de la diode redevient brusquement non nulle et le courant inverse recommence à croître pour ensuite s'annuler.

A l'instant $t_1$, où le courant dans la diode est égal au courant inverse maximum $I_{RM}$, le courant I, circulant dans le transistor T et dans l'inductance $L_1$ prend la valeur :

$$I(t_2) = I_0 + I_{RM}$$

où $I_0$ représente la valeur du courant dans l'inductance principale (L).

A l'instant $t_2$, où le courant dans la diode s'annule et en négligeant, comme il est usuel de le faire du fait de l'ordre de grandeur habituellement choisi des composants, le courant dérivé par le réseau $RCD_1$, le courant dans l'inductance $L_1$ prend la valeur :

$$I(t_2) \simeq I_0$$

Il en résulte, entre ces deux instants, une variation rapide de courant dans l'inductance $L_1$ et donc une surtension $\delta V$ aux bornes de celle-ci :

$$\delta V = L_1 \frac{dI}{dt} \simeq L_1 \frac{I_{RM}}{t_2 - t_1}$$

La diode est alors le siège d'une dissipation d'énergie d'autant plus grande que la tension $V_D$ à ses bornes est alors grandi (zone hachurée sur la figure 3C)

$$V_D = E + \delta V$$

$$W_D = \int_{t_1}^{t_2} V_D I_D$$

où $I_D$ représente le courant inverse circulant dans la diode pendant sa phase de recouvrement, entre $I_{RM}$ et zéro.

La présente invention permet d'éviter cet inconvénient par une adaptation judicieuse du dispositif d'aide à la commutation du transistor T.

Son originalité réside dans les faits suivants :

-on procure un chemin de dérivation "R-C" pour écouler l'excès de courant $I_{RM}$ présent au noeud A au moment du reblocage de la diode D ;

-on utilise le condensateur C comme dispositif d'aide à la commutation, à la fois pour le transistor T et pour la diode D ;

-on prend soin de choisir de choisir une résistance R non inductive et de très faible valeur.

Suivant l'invention, le dispositif d'aide à la commutation d'interrupteur et de diode de roue libre utilisé dans un réseau électrique comportant, outre cet interrupteur et cette diode de roue libre, une inductance, ces trois composants étant répartis sur trois branches différentes aboutissant à un même noeud, formant ainsi un tripôle connecté par ailleurs à une source de tension d'alimentation et à une charge, de sorte que la charge est alimentée, soit via la source de tension d'alimentation, l'interrupteur et l'inductance, soit via l'inductance et la diode de roue libre, suivant que l'interrupteur est conducteur ou bloqué, et, corralétivement, suivant que la diode de roue libre est bloquée ou conductrice, ce dispositif d'aide à la commutation de l'interrupteur comportant d'une part un circuit d'aide à la mise en conduction de l'interrupteur comportant lui-même un circuit "R-L₁", placé en série avec l'interrupteur, et d'autre part un circuit d'aide au blocage de l'interrupteur, comportant lui-même un circuit "R-C" placé en parallèle sur l'interrupteur, est caractérisé en ce que la résistance R est choisie non inductive et de valeur suffisamment faible pour que le produit $R.I_{RM}$ où ($I_{RM}$ désigne le courant inverse maximum de la diode de roue libre) soit inférieur à E, où E désigne la tension d'alimentation.

La présente invention sera mieux comprise en se reportant à la description suivante et aux figures qui l'accompagnent, parmi lesquelles, outre les figures 1, 2 et 3 déjà étudiées :

-les figures 4a, 4b et 4c sont des diagrammes représentant respectivement le courant $I_T$ dans le transistor T, le courant $I_D$ dans la diode D et la tension $V_D$ aux bornes de la diode dans le cas d'un dispositif d'aide à la commutation adapté suivant l'invention ;

-la figure 5 est une variante de réalisation du circuit de la figure 1.

Suivant l'invention la résistance R est choisie de façon à ce que le courant inverse soit entièrement dérivé dans le circuit "R-C", ce qui permet, puisque le condensateur C est chargé à la valeur E à l'instant $t_1$ considéré, d'annuler la valeur E dans l'expression de la tension $V_D$ aux bornes de la diode à cet instant, donc de réduire la puissance dissipée dans celle-ci. Dans ce cas la tension $V_D$ aux bornes de la diode D, à partir de l'instant $t_1$, est donnée par l'expression :

$$V_D(t) = E + R I_D(t) - (E - t \frac{dV_c}{dt}),$$

où $E - t \dfrac{dV_c}{dt}$ représente la tension aux bornes du condensateur C,

avec $\dfrac{dV_c}{dt} = \text{constante} = \dfrac{I_{RM}}{C}$,

soit : $V_D(t) = R I_D(t) - t \dfrac{I_{RM}}{C}$

A l'instant $t_1$, la tension $V_D$ a donc pour valeur :

$$V_D(t_1) = R I_{RM}$$

On note que le courant dans la résistance R passe très rapidement de 0 à $I_{RM}$. Il est important de choisir une résistance non inductive si on veut éviter l'inconvénient d'une surtension lors de l'établissement de ce courant.

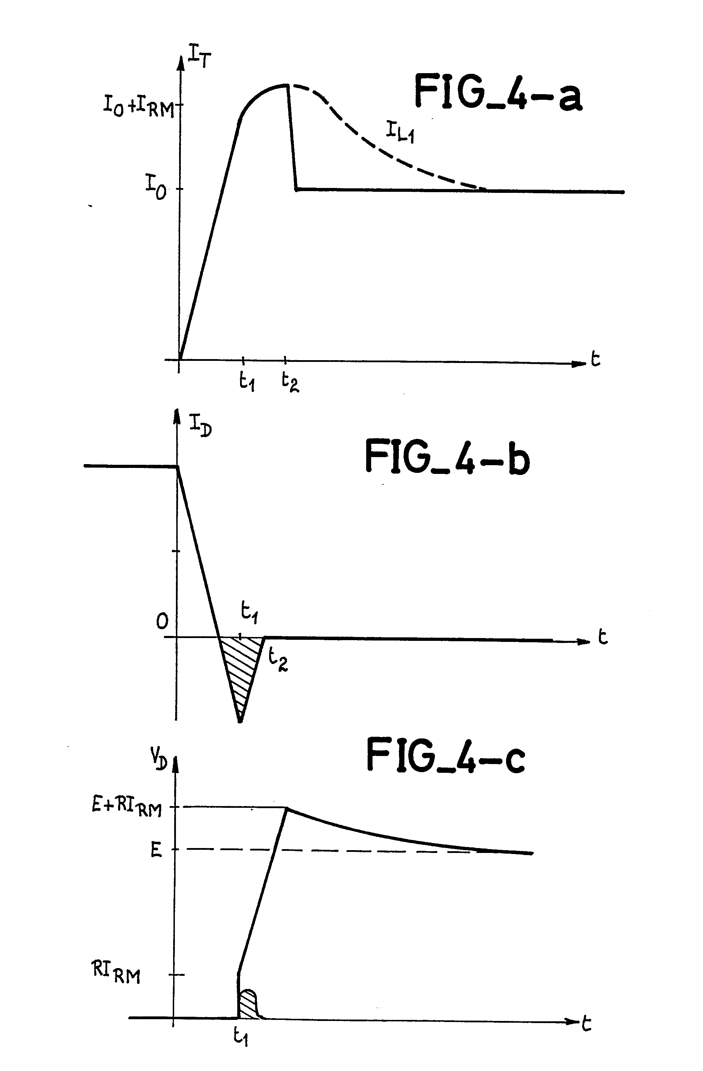

Suivant l'invention la valeur $R I_{RM}$ est choisie inférieure à la tension d'alimentation E, ce qui donne une tension $V_D(t_1)$ très inférieure à la valeur $E + \delta V$ trouvée précédemment. Par ailleurs, entre les instants $t_1$ et $t_2$, la tension $V_D$ croît progressivement, et non pas brutalement comme c'était le cas auparavant. Tout ceci fait qu'entre les instants $t_1$ et $t_2$, la puissance dissipée dans la diode, représentée par la zone hachurée sur la figure 4c, est très inférieure à ce qu'elle était auparavant.

, étant représenté en pointillés sur la figure 4a. La tension $V_D$ passe alors par une valeur $E + RI_{RM}$ avant de décroître exponentiellement vers la valeur E.

La variante de réalisation représentée sur la figure 5 est destinée à compenser l'inconvénient que pourrait constituer, pour des temps de blocage du transistor très courts, le choix d'une valeur de la résistance R faible. Cet inconvénient est compensé par l'adjonction, en série avec la diode $D_1$, d'un circuit de démagnétisation, comportant un condensateur $C_1$ en parallèle avec une résistance $R_1$.

**Revendications**

1. Dispositif d'aide à la commutation d'interrupteur (T) et de diode de roue libre (D) utilisés dans un réseau électrique comportant par ailleurs une inductance (L), ces trois composants étant répartis sur trois branches différentes aboutissant à un même noeud (A), formant ainsi un tripôle connecté par ailleurs à une source de tension d'alimentation (E) et à une charge (Z), de sorte que la charge est alimentée, soit via la source de tension d'alimentation, l'interrupteur et l'inductance, soit via l'inductance et la diode Lorsque le condensateur C est complètement déchargé, la diode $D_1$ entre en conduction et permet l'amortissement du courant inverse excédentaire dans la boucle $L_1$-R, le courant correspondant dans l'inductance $L_1$ :

de roue libre, suivant que l'interrupteur (T) est conducteur ou bloqué, et, corralétivement, suivant que la diode de roue libre (D) est bloquée ou conductrice, dispositif d'aide à la commutation comportant d'une part un circuit d'aide à la mise en conduction de l'interrupteur, comportant lui-même un circuit "R-$L_1$" placé en série avec l'interrupteur, et d'autre part un circuit d'aide au blocage de l'interrupteur, comportant lui-même un circuit "R-C" placé en parallèle sur l'interrupteur, caractérisé en ce que la résistance R est choisie non inductive et de valeur suffisamment faible pour que le produit $R.I_{RM}$ (où $I_{RM}$ désigne le courant inverse maximum de la diode de roue libre) soit inférieur à la tension d'alimentation (E).

2. Dispositif selon la revendication 1, caractérisé en ce que le circuit "R-$L_1$" comporte en outre un circuit de démagnétisation.

3. Dispositif selon la revendication 2, caractérisé en ce que le circuit de démagnétisation comporte un condensateur - ($C_1$) en parallèle avec une résistance ($R_1$)

FIG_1

FIG_2

FIG_5

FIG_3-a

FIG_3-b

FIG_3-c

$I_T$

$I_0 + I_{RM}$

$I_0$

$t_1$  $t_2$

$t$

# FIG_4-a

$I_{L1}$

$I_D$

# FIG_4-b

$0$

$t_1$

$t_2$

$t$

$V_D$

# FIG_4-c

$E + RI_{RM}$

$E$

$RI_{RM}$

$t_1$

$t$

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | ELECTRONIQUE ET APPLICATIONS INDUSTRIELLES, no. 245, 1 décembre 1977, pages 15-20, Paris, FR; H. FOCH et al.: "Réalisation d'un hacheur à courant continue pour réseaux 380 V alternatifs redressés" * Page 15; figure 2 * | 1 | H 02 M 3/155 H 03 K 17/08 |
| A | FR-A-2 547 106 (HENNEVIN) | | |

DOMAINES TECHNIQUES RECHERCHES (Int. Cl.4)

H 02 M 1/00
H 02 M 3/00
H 03 K 17/00

Le présent rapport de recherche a été établi pour toutes les revendications

| Lieu de la recherche | Date d'achèvement de la recherche | Examinateur |
|---|---|---|
| LA HAYE | 12-06-1986 | BERTIN M.H.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82